# EUROPEAN PATENT APPLICATION

(11) **EP 4 776 811 A1**
(43) Date of publication of application: **15.07.2026**
(21) Application number: 25216896.8
(22) Date of filing: 19.11.2025
(51) Int. Cl.: H10K 59/80

(54) **ELECTRONIC DEVICE**

(30) Priority: 10.01.2025 CN 202510041906
(71) Applicant: InnoLux Corporation, Chu-Nan, Miao-Li 350 (TW)
(72) Inventor: TSAI, PING-HSUN, Jhu-Nan 350 Miao-Li County (TW); YAO, I-AN, Jhu-Nan 350 Miao-Li County (TW)
(74) Representative: dompatent

(57) **Abstract**

An electronic device includes a first substrate, a plurality of electronic units, a reflective layer and a reflectivity matching layer. The first substrate has an active area and a peripheral area. The electronic units are disposed on the first substrate and located within the active area. The reflective layer is disposed above the first substrate and relatively overlaps the active area of the first substrate, and the reflective layer has a plurality of openings relatively overlapping the electronic units, respectively. The reflectivity matching layer is disposed above the first substrate and relatively overlaps the peripheral area of the first substrate.

## Description

### BACKGROUND

### Technology Field

This invention relates to an electronic device and, in particular, to a mirror display device.

### Description of Related Art

With the development of digital technology, display devices have been widely used in various aspects of daily life, such as TVs, computers, mobile phones, and other modern information products. In recent years, display devices (e.g. the mirror display devices) that are integrated into different application environments have been introduced and gradually popularized. However, the display area (active area) and non-display area (peripheral area) of the display device usually have different reflective indexes, so that when the display device is not lit, the user can notice a visual difference between the two areas.

### SUMMARY

This invention provides an electronic device that provide matching reflections in the display area (active area) and the non-display area (peripheral area) of the display device, thereby achieving the effect of a hidden display screen.

An electronic device of this invention includes a first substrate, a plurality of electronic units, a reflective layer and a reflectivity matching layer. The first substrate has an active area and a peripheral area. The electronic units are disposed on the first substrate and located within the active area. The reflective layer is disposed above the first substrate and relatively overlaps the active area of the first substrate. The reflective layer has a plurality of openings relatively overlapping the electronic units, respectively. The reflectivity matching layer is disposed above the first substrate and relatively overlaps the peripheral area of the first substrate.

### BRIEF DESCRIPTION OF THE DRAWINGS

The invention will become more fully understood from the detailed description and accompanying drawings, which are given for illustration only, and thus are not limitative of the present invention, and wherein:
FIG. 1 is a schematic sectional view showing an electronic device according to a first embodiment of this invention;
FIGS. 2A and 2B are schematic sectional views showing different aspects of an electronic device according to a second embodiment of this invention;
FIGS. 3A and 3B are schematic sectional views showing different aspects of an electronic device according to a third embodiment of this invention;
FIG. 4 is a schematic sectional view showing an electronic device according to a fourth embodiment of this invention;
FIGS. 5A and 5B are schematic sectional views showing different aspects of an electronic device according to a fifth embodiment of this invention; and
FIGS. 6A and 6B are schematic sectional views showing different aspects of an electronic device according to a sixth embodiment of this invention.

### DETAILED DESCRIPTION OF THE INVENTION

It should be understood that the following description provides different embodiments for implementing different aspects of some embodiments of the present invention. The specific components and arrangements described below are used to briefly and clearly describe some embodiments of the present disclosure. These embodiments are for illustrations and are not intended to limit the scope of the present disclosure. In addition, reference numbers or labels may be repeatedly used in different embodiments. These repetitions are for the purpose of simply and clearly describing some embodiments of the present disclosure, and do not represent any correlation between the different embodiments and/or structures discussed. Furthermore, when it is mentioned that a certain layer is on or above another layer, the certain layer may directly contact another layer, or one or more other layers or films may be provided between the two layers, so that the certain layer may not directly contact another layer.

Relative terms, such as "lower" and "higher", or "bottom" and "top", may be used in following embodiments to describe the relative relationship of one component to another component in the drawings. It will be understood that if the device shown in the drawings is turned upside down, components described as being at the "lower" side would then be at the "higher" side.

The terms "about", "approximate" and "approximately" usually mean the variation within 20%, preferably within 10%, and more preferably within 5%, 3%, 2%, 1% or 0.5% of a given value or range. The given quantities here are approximate quantities, that is, in the absence of specific description of "about", "approximate", or "approximately", the meaning of "about", "approximate", and "approximately" can still be implied.

It will be understood that, although the terms "first", "second", "third" and the likes may be used herein to describe various elements, components, regions, layers, and/or portions, these elements, components, regions, layers, and/or portions should not be limited by these terms, and these terms are used to distinguish between different elements, components, regions, layers, and/or portions. Thus, a first element, component, region, layer, and/or portion discussed below could be termed a second element, component, region, layer, and/or portion without departing from the teachings of some embodiments of the present disclosure.

Unless otherwise defined, all terms (including technical and scientific terms) used herein have the same meaning as commonly understood by one of ordinary skill in the related art. It is understood that these terms, such as those defined in commonly used dictionaries, should be interpreted to have a meaning consistent with the relevant technology and the background or content of the present disclosure, and should not be interpreted in an idealized or overly formal way, unless otherwise defined in the embodiments of this disclosure.

Some embodiments of the present disclosure can be understood together with the drawings, and the drawings of the embodiments of the present disclosure are also regarded as part of the description of the embodiments of the present disclosure. It should be understood that the drawings of the embodiments of the present disclosure are not drawn to the actual scale of devices and components. The shapes and thicknesses of embodiments may be exaggerated in the drawings to clearly illustrate features of embodiments of the present disclosure. In addition, the structures and devices in the drawings are illustrated in a schematic manner in order to clearly demonstrate the features of the embodiments of the present disclosure.

In some embodiments of the present disclosure, relative terms such as "lower", "upper", "parallel", "vertical", "below", "above", "top", "bottom", etc., shall be understood as the orientations shown in this paragraph and related drawings. This relative terms are for convenience of explanation and does not mean that the device described needs to be manufactured or operated in a specific orientation. Terms related to joining and connecting, such as "connect", "joint", etc., unless otherwise defined, can mean that two structures are in direct contact, or they can also mean that the two structures are not in direct contact with one or more additional structures located therebetween. The terms related to joining and connecting two structures can also include the situation that both structures are movable, or both structures are fixed.

To be noted, without departing from the spirit of the present invention, the features in several different embodiments may be replaced, reorganized, or mixed to complete other embodiments.

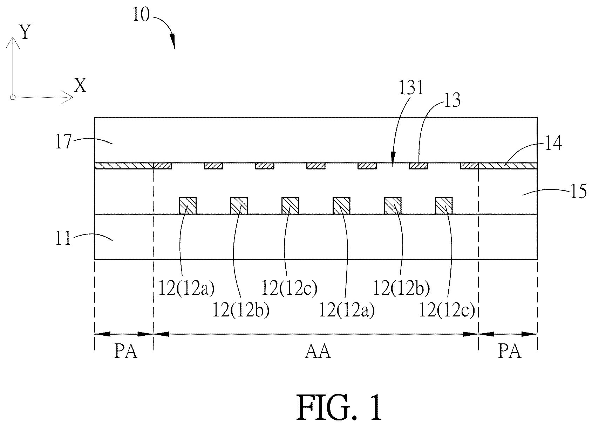

Referring to FIG. 1, the electronic device 10 includes a first substrate 11, a plurality of electronic units 12, a reflective layer 13, and a reflectivity matching layer 14. In addition, the electronic device 10 can further include an intermediate layer 15 and a second substrate 17.

As shown in FIG. 1, the first substrate 11 includes an active area AA and a peripheral area PA, and the electronic units 12 are disposed on the first substrate 11 and located within the active area AA. The intermediate layer 15 is disposed on the first substrate 11 and the electronic units 12. The reflective layer 13 is disposed on one surface of the intermediate layer 15 away from the first substrate 11, and overlaps the active area AA of the first substrate 11 in the second direction Y. The reflective layer 13 includes a plurality of openings 131, which overlap the electronic units 12, respectively, in the second direction Y. The reflectivity matching layer 14 is disposed on one surface of the intermediate layer 15 away from the first substrate 11, and overlaps the peripheral area PA of the first substrate 11 in the second direction Y. The second substrate 17 is disposed opposite to the first substrate 11, so that the electronic units 12, the reflective layer 13, the reflectivity matching layer 14 and the intermediate layer 15 are located between the first substrate 11 and the second substrate 17. The reflective layer 13 and the reflectivity matching layer 14 are disposed on one surface of the second substrate 17 close to the first substrate 11.

As mentioned above, the active area AA is roughly defined in the central area of the first substrate 11, and the peripheral area PA is roughly defined in the peripheral area of the first substrate 11 and can be, for example, arranged around the active area AA. The first substrate 11 may include, for example but not limited to, transparent or opaque organic materials and/or inorganic materials, and the material of the first substrate 11 may include rigid material or flexible soft material. The organic material may include polyimide (PI), polycarbonate (PC), polyethylene terephthalate (PET), any of other known suitable materials, or any combination thereof, and this invention is not limited thereto. The inorganic material may include glass, quartz, sapphire or ceramic, and this invention is not limited thereto. In this embodiment, the material of the first substrate 11 is, for example, glass, so the first substrate 11 is a glass substrate.

To be noted, the first substrate 11 may be provided with a circuit layer (not shown), which may include, for example, different passive components and/or active components, such as resistors, capacitors, inductors, diodes, MOSFET, CMOS transistors, BJTs, LDMOS transistors, PMOS transistors, TFTs, or other types of transistors. The first substrate 11 and the circuit layer may together constitute a driving substrate for driving and/or controlling the electronic units 12, which can be, for example but not limited to, a CMOS substrate, an LCOS substrate, a TFT substrate, or other circuit substrates with operating circuits. The part of the circuit layer in the active area AA may include, for example but not limited to, signal lines for respectively conducting the electronic units 12, such as scan lines and data lines, and the other part of the circuit layer in the peripheral area PA may include, for example but not limited to, a driving control circuit for controlling and driving each electronic unit 12, such as a scan driver and a data driver. In this embodiment, the first substrate 11 and the circuit layer constitute a TFT substrate, for example.

In this embodiment, the electronic device 10 can be, for example, a display device, especially a mirror display device. The active area AA can correspond to the display area of the mirror display device, and the peripheral area PA can correspond to the non-display area of the mirror display device.

In this embodiment, the electronic unit 12 may be, for example but not limited to, a light-emitting unit, and the light-emitting unit (electronic unit 12) may be electrically connected to the circuit layer of the first substrate 11. In other embodiments, each electronic unit 12 may include any suitable active or passive component. In practice, for example, a pixel definition layer may be first formed on the first substrate 11. The pixel definition layer may be, for example, made of a negative photoresist and have a plurality of accommodation spaces. Each light-emitting unit (electronic unit 12) may, for example, include three light-emitting elements 12a, 12b and 12c, which are respectively disposed in the accommodation spaces of the pixel definition layer. For example, each light-emitting element 12a, 12b or 12c may include an organic LED (OLED), an inorganic LED (e.g., mini LED or micro LED), or a quantum-dot LED (QLED), but this invention is not limited thereto. Each of the light-emitting elements 12a, 12b and 12c generally has a certain degree of reflective property. For example, the LED has a reflectivity of more than 30%, and an OLED has a reflectivity of more than 60%. In this embodiment, the three light-emitting elements 12a, 12b and 12c of each light-emitting unit (electronic unit 12) may be, for example, a red micro LED, a green micro LED, and a blue micro LED, respectively. In practice, the plural electronic units 12 disposed on the first substrate 11 can be arranged in an array. In other words, a micro LED array, which includes a plurality of micro LEDs arranged in an array, can be formed on the first substrate 11. In other embodiments, an OLED array or an array of other light-emitting elements can be formed on the first substrate 11, and this invention is not limited thereto.

The intermediate layer 15 can be, for example but not limited to, an air medium, an optical clear adhesive (OCA), an optical clear resin (OCR), or the likes, and this invention is not limited thereto. In one embodiment, the surface of the intermediate layer 15 away from the first substrate 11 can be a planarized surface, so that the intermediate layer 15 can be, for example, a planarization layer.

The reflective layer 13 is disposed on the lower surface of the second substrate 17 and overlaps the active area AA of the first substrate 11 in the second direction Y. In this embodiment, a layer of reflective material may be first formed on the lower surface of the second substrate 17, and then parts of the layer of reflective material corresponding to the light-emitting elements 12a, 12b and 12c of the electronic unit 12 are removed to form the reflective layer 13 having a plurality of openings 131. To be noted, the width (in the first direction X) of each opening 131 may be equal to or slightly greater than the width of the corresponding light-emitting element 12a, 12b or 12c, and this invention is not limited thereto. The material of the reflective layer 13 may include, for example, a metal material (e.g., a single metal layer or a composite metal layer), a multilayer structure (e.g., a multilayer film material) formed by alternately stacking at least one high refractive index layer and at least one low refractive index layer, or any of other suitable materials. The single metal layer may include, for example, silver, aluminum, or the likes. The composite metal layer may include, for example, a composite structure of materials such as metals and metal oxides, which can be, for example but not limited to, ITO/Ag/ITO, Ag/ITO, Al/Ag/Al, Ag/Al, or the likes. The multilayer film material may include, for example, a multilayer film having at least three layers, in which the high refractive index layers and the low refractive index layers are alternately stacked. The material of the low refractive index layer may be, for example, silicon oxide (SiOx), and the material of the high refractive index layer may be, for example, silicon nitride (SiNx), niobium oxide (Nb₂O₅), or the likes. This invention is not limited thereto.

The reflectivity matching layer 14 is disposed on the lower surface of the second substrate 17 and overlaps the peripheral area PA of the first substrate 11 in the second direction Y. That is, the reflectivity matching layer 14 can be disposed around the reflective layer 13. The material of the reflectivity matching layer 14 may include a metal material (e.g., a single metal layer or a composite metal layer), a multilayer structure (e.g., a multilayer film material) formed by alternately stacking at least one high refractive index layer and at least one low refractive index layer, or any of other suitable materials. The single metal layer may include, for example, silver, aluminum, or the likes. The composite metal layer may include, for example, a composite structure of materials such as metals and metal oxides, which can be, for example but not limited to, ITO/Ag/ITO, Ag/ITO, Al/Ag/Al, Ag/Al, or the likes. The multilayer film material may include, for example, a multilayer film having at least three layers, in which the high refractive index layers and the low refractive index layers are alternately stacked. The material of the low refractive index layer may be, for example, silicon oxide (SiOx), and the material of the high refractive index layer may be, for example, silicon nitride (SiNx), niobium oxide (Nb₂O₅), or the likes. This invention is not limited thereto. In this embodiment, the reflectivity of the reflectivity matching layer 14 is mainly matched to the reflectivity of the reflective layer 13. For example, with respect to visible light, the difference in average reflectivity across the visible light spectrum between the reflectivity of the reflectivity matching layer 14 and the reflectivity of the reflective layer 13 can be less than or equal to 20%. The configuration of the reflectivity matching layer 14 can provide a matching reflection effect in the active area AA (e.g. the display area) and the peripheral area PA (e.g. the non-display area) of the electronic device 10 (e.g. a mirror display device), so both the active area AA and the peripheral area PA can be functioned as mirrors, thereby achieving the purpose of a hidden display screen. In the electronic device 10 according to one embodiment of this invention, with respect to visible light, the reflectivity of the active area AA is similar to the reflectivity corresponding to the peripheral area PA. For example, the difference between the difference in average reflectivity across the visible light spectrum between the reflectivity of the active area AA and the peripheral area PA is less than or equal to 15%. In some cases, the difference in average reflectivity across the visible light spectrum between the reflectivity of the active area AA and the peripheral area PA is less than or equal to 5%.

The second substrate 17 can be, for example but not limited to, a transparent substrate, such as a glass substrate, and this invention is not limited thereto. As shown in FIG. 1, the second substrate 17 is disposed on the intermediate layer 15. In the active area AA, the reflective layer 13 is formed on the lower surface of the second substrate 17. In the peripheral area PA, the reflectivity matching layer 14 is formed on the lower surface of the second substrate 17. In one embodiment, when manufacturing the electronic device 10, the electronic units 12 can be disposed on the active area AA of the first substrate 11, and the reflective layer 13 and the reflectivity matching layer 14 are disposed on the second substrate 17. For example, a layer of reflective material can be first formed on a surface of the second substrate 17, and then parts of the layer of reflective material corresponding to the light-emitting elements 12a, 12b and 12c of the electronic unit 12 can be removed, for example, by a photolithography process or laser ablation, thereby forming a reflective layer 13 having a plurality of openings 131 within the active area AA. In addition, a reflectivity matching layer 14 can be formed around the reflective layer 13 (corresponding to the peripheral area PA). Then, a sealant can be used to bond the first substrate 11 and the second substrate 17, so that the electronic units 12, the reflective layer 13 and the reflectivity matching layer 14 can be arranged between the first substrate 11 and the second substrate 17. The reflective layer 13 overlaps the active area AA of the first substrate 11 in the second direction Y, and the plurality of openings 131 of the reflective layer 13 respectively overlaps the light-emitting elements 12a, 12b 12c of the electronic unit 12 in the second direction Y. The reflectivity matching layer 14 overlaps the peripheral area PA of the first substrate 11 in the second direction Y. In this case, the intermediate layer 15 can be, for example, an air medium. In another embodiment, a layer of adhesive material can be provided to bond the structure on the first substrate 11 and the structure on the second substrate 17. The layer of adhesive material can be, for example, an OCA or an OCR. In this case, the intermediate layer 15 can be, for example, a layer including the OCA or OCR.

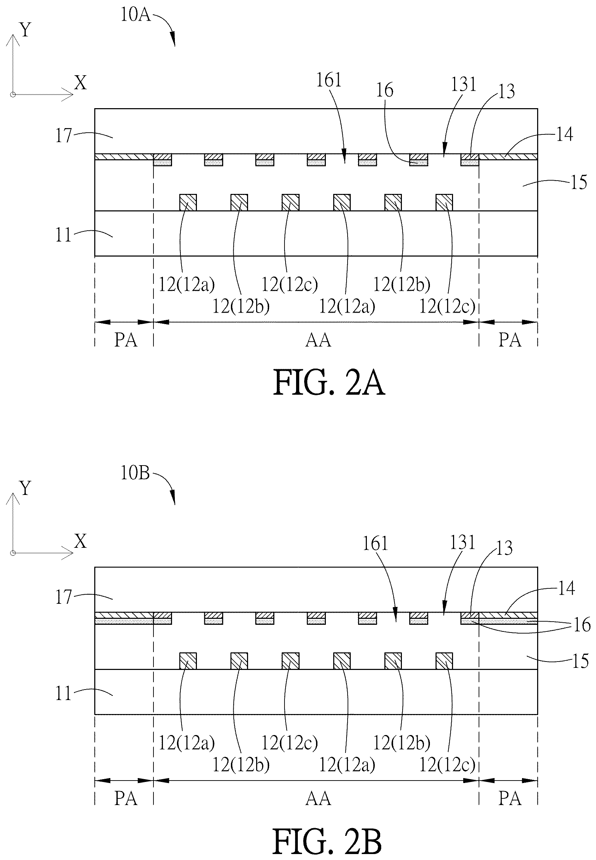

As shown in FIG. 2A, compared with the previous embodiment of FIG. 1, the electronic device 10A further includes a light absorbing layer 16 disposed at one side of the reflective layer 13 close to the first substrate 11. In this embodiment, a layer of reflective material may be first formed on the lower surface of the second substrate 17, and then the parts of the layer of reflective material corresponding to the light-emitting elements 12a, 12b and 12c of the electronic units 12 are removed, for example, by a photolithography process or laser ablation, so as to form a reflective layer 13 having a plurality of openings 131. Then, a layer of light absorbing material (e.g. black photoresist material) may be formed on the reflective layer 13 to form a light absorbing layer 16. In this case, the openings 161 of the light absorbing layer 16 are correspondingly arranged on the openings 131 of the reflective layer 13. In addition, a reflectivity matching layer 14 can be formed around the reflective layer 13 (corresponding to the peripheral area PA). Then, the first substrate 11 and the second substrate 17 can be bonded, so that the electronic units 12, the reflective layer 13, the reflectivity matching layer 14 and the light absorbing layer 16 are all arranged between the first substrate 11 and the second substrate 17. The bonding method of the two substrates can refer to the aforementioned embodiment and will not be described in detail herein. To be noted, the above description is for an illustration and is not intended to limit the scope of the present invention. In another embodiment, a layer of reflective material can be formed on the lower surface of the second substrate 17, and then a layer of light absorbing material can be formed on the layer of reflective material. Then, the openings 131 and the openings 161 are formed in the layer of reflective material and the layer of light absorbing material respectively by, for example, a photolithography process or laser ablation, so as to form the reflective layer 13 and the light absorbing layer 16 stacked on the second substrate 17.

In this embodiment, the light absorbing layer 16 may be, for example but not limited to, a black photoresist layer, which may have a plurality of openings 161. The openings 161 of the light absorbing layer 16 correspond to the openings 131 of the reflective layer 13, respectively. Therefore, the light absorbing layer 16 is formed at one side of the reflective layer 13 close to the first substrate 11, and may form a black matrix layer (BM). The main function of the light absorbing layer 16 (BM) is to reduce the cross-talk between the light-emitting elements 12a, 12b and 12c (i.e., subpixels). As shown in FIG. 2A, the reflective layer 13 is stacked on the light absorbing layer 16. The width of the light absorbing layer 16 in the first direction X may be, for example, less than or equal to the width of the reflective layer 13, and the width of the light absorbing layer 16 may be, for example, greater than or equal to 50% of the width of the reflective layer 13. This invention is not limited thereto. In some embodiments, the distance between the side edge of the light absorbing layer 16 and the corresponding side edge of the reflective layer 13 in the first direction X is between 1 µm and 5 µm, but this invention is not limited thereto.

The detailed description of other features of the electronic device 10A can refer to the previous embodiment, and will be omitted here.

As shown in FIG. 2B, compared with the previous embodiment of FIG. 2A, in the electronic device 10B, the light absorbing layer 16 is further disposed at one side of the reflectivity matching layer 14 close to the first substrate 11.

The detailed description of other features of the electronic device 10B can refer to the previous embodiment, and will be omitted here.

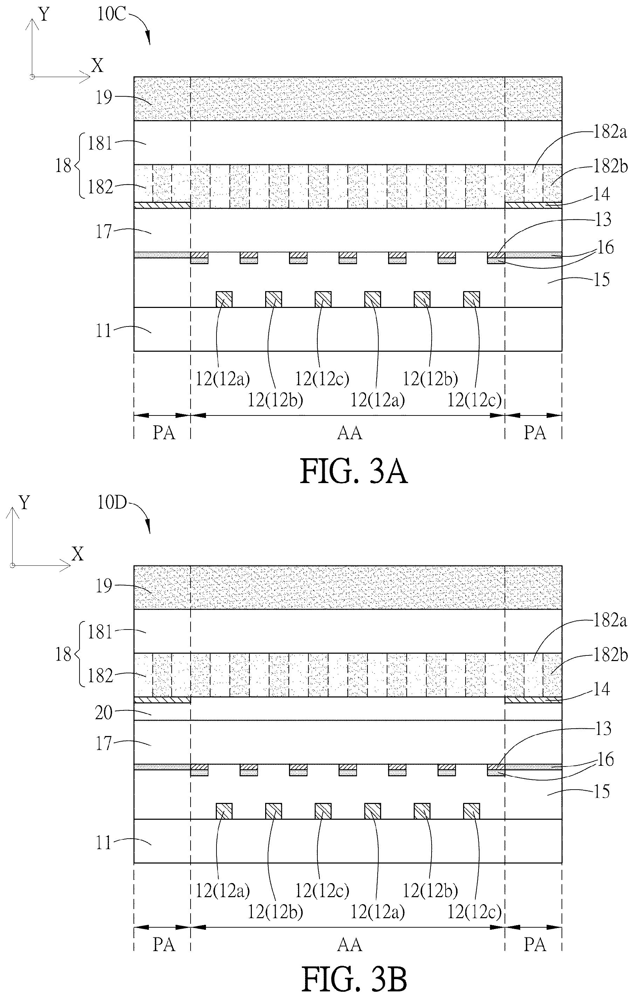

As shown in FIG. 3A, compared with the previous embodiment of FIG. 2B, the electronic device 10C further includes a circular polarizing layer 18 and an anti-reflective layer 19. The second substrate 17 is disposed opposite to the first substrate 11, so that the plurality of electronic units 12 are disposed between the first substrate 11 and the second substrate 17. The reflective layer 13 is disposed at one side of the second substrate 17 close to the first substrate 11, and the reflectivity matching layer 14 is disposed at one side of the second substrate 17 away from the first substrate 11. The circular polarizing layer 18 is disposed above the reflective layer 13 and the reflectivity matching layer 14. The circular polarizing layer 18 can be, for example, directly formed on one side of the second substrate 17 away from the first substrate 11. The anti-reflective layer 19 is disposed on one side of the circular polarizing layer 18 away from the first substrate 11.

In this embodiment, the second substrate 17 can be, for example but not limited to, a transparent substrate, such as a glass substrate, and this invention is not limited thereto. As shown in FIG. 3A, the second substrate 17 is formed on the intermediate layer 15. In the active area AA, the reflective layer 13 is formed on the lower surface of the second substrate 17, and the light absorbing layer 16 is formed on one side of the reflective layer 13 close to the first substrate 11. In the peripheral area PA, the light absorbing layer 16 is formed on the lower surface of the second substrate 17, and the reflectivity matching layer 14 is formed on the upper surface of the second substrate 17.

In addition, the circular polarizing layer 18 includes, for example, a linear polarizer 181 and a phase retarder 182. The linear polarizer 181 is disposed on the phase retarder 182, and the phase retarder 182 is disposed on the second substrate 17.

In one embodiment, the phase retarder 182, for example, includes a first portion 182a and a second portion 182b arranged next to each other in the first direction X. The first portion 182a includes a first fast axis, and the second portion 182b includes a second fast axis. The first portion 182a overlaps one or more electronic units 12 in the second direction Y, and the second portion 182b overlaps one or more other electronic units 12 in the second direction Y. This invention is not limited thereto. To be noted, the first portions 182a and the second portions 182b as shown in FIG. 3A are merely exemplary. In actual applications, the first portion 182a and the second portion 182b may each include a preset pattern. For example, the preset pattern of the first portion 182a may be a plurality of parallel stripes, and the preset pattern of the second portion 182b may be a plurality of parallel stripes between the parallel stripes (the preset pattern) of the first portion 182a. In another embodiment, the preset pattern of the first portion 182a may be a plurality of wood grains, hair lines, cloud patterns, wavy stripes or the likes, and the preset pattern of the second portion 182b may be an area other than the preset pattern of the first portion 182a. In another embodiment, the preset pattern of the first portion 182a may be a specific pattern, such as a string of characters, an item pattern, a trademark, a character graphic, or the likes, and the preset pattern of the second portion 182b may be an area other than the preset pattern of the first portion 182a. The above description is for an illustration and is not intended to limit the scope of the present invention. The preset patterns of the first portion 182a and/or the second portion 182b can be designed according to actual needs and are not limited by this invention.

In this embodiment, the phase retarder 182 may be formed by, for example, a coating process, and may be patterned by a photolithography process or laser ablation to form the first portion 182a and the second portion 182b having predetermined patterns. In details, in the process of forming the phase retarder 182, a suitable solute may be placed in a solvent to form a lyotropic liquid crystal. A typical solute may include an organic material (amphiphilic molecule) having both a hydrophilic group and a lipophilic group, such as alkali metal fatty salts (e.g. sodium dodecyl sulfate or sodium fatty acid), and the solvent may be water or any of other polar solvents. The required liquid crystal form can be formed by selecting the type of solvent and the concentration of the organic material. Then, the lyotropic liquid crystal solution is coated on the second substrate 17, and patterned by a photolithography process or laser ablation to form, for example, a preset pattern of the first portion 182a. After removing the solvent therein, the structure of the lyotropic liquid crystal may be solidified to form the first portion 182a of the phase retarder 182. By selecting suitable solute and solvent and adjusting a suitable concentration, the first portion 182a can have a first fast axis. Then, the second portion 182b of the phase retarder 182 may be formed in the same manner, and the second portion 182b may have a second fast axis. It should be noted that the angle of the first fast axis and the angle of the second fast axis can be controlled by using the lyotropic liquid crystals of different concentrations or solutes. In addition, in the phase retarder 182, the liquid crystal molecules with fixed structures can be in the disc-shaped structure, a rod-shaped structure, or a rod-shaped structure doped with chiral molecules, and this invention is not limited thereto. In addition, in this embodiment, the phase retardation of the first portion 182a for the incident light from the environment can be the same as or different from the phase retardation of the second portion 182b for the incident light from the environment, and this invention is not limited thereto.

The linear polarizer 181 is disposed at one side of the phase retarder 182 away from the second substrate 17, and includes a transmission axis. The included angle between the first fast axis of the first portion 182a of the phase retarder 182 and the transmission axis of the linear polarizer 181 is different from the included angle between the second fast axis of the second portion 182b of the phase retarder 182 and the transmission axis of the linear polarizer 181. In this embodiment, the linear polarizer 181 is disposed on the upper surface of the phase retarder 182. For example, the linear polarizer 181 can be formed on the first portion 182a and the second portion 182b of the phase retarder 182 by a coating process. In some cases, the linear polarizer 181 can be patterned by a photolithography process or laser ablation. In details, in the process of forming the linear polarizer 181, the lyotropic liquid crystal and the dichroic dye may be mixed first, and then the mixed material may be coated on the phase retarder 182. The color of the light allowed to pass through the linear polarizer 181 may be adjusted by selecting a proper dichroic dye, and the color of the reflected light can be controlled accordingly.

Therefore, regardless of whether the phase retardations of the first portion 182a and the second portion 182b of the phase retarder 182 are the same or different, as long as the fast axis (first fast axis) of the first portion 182a can be controlled to be different from the fast axis (second fast axis) of the second portion 182b, so that the angle between the first fast axis and the transmission axis is different from the angle between the second fast axis and the transmission axis, in cooperated with the high reflectivity of the electronic unit 12, the circuit layer (e.g., including metal lines) of the first substrate 11, the reflective layer 13 and the reflectivity matching layer 14, the area corresponding to the first portion 182a and the area corresponding to the second portion 182b can generate different reflected lights, such as different brightness and/or different colors, etc. Therefore, when the electronic device 10C is not lit, the aforementioned preset pattern, such as parallel stripes, wood grains, hair lines, cloud patterns, wavy stripes, a string of characters, an item pattern, a trademark, a character graphic, or the likes, can be viewed from the outer side of the electronic device 10C (e.g., display surface side).

In another embodiment, as shown in FIG. 3A, the phase retardation of the first portion 182a of the phase retarder 182 is different from the phase retardation of the second portion 182b of the phase retarder 182. It should be noted that in this embodiment, the angle between the fast axis of the first portion 182a and the transmission axis of the linear polarizer 181 may be the same as or different from the angle between the fast axis of the second portion 182b and the transmission axis of the linear polarizer 181, and this invention is not limited thereto.

In this embodiment, the phase retarder 182 may be formed by, for example, a coating process, and may be patterned by a photolithography process or laser ablation. After repeating the aforementioned patterning process several times, a first portion 182a and a second portion 182b having a preset pattern and being non-uniform may be formed. In other words, the phase retarder 182 may be a single-layer or multi-layer structure, and may be formed with a first portion 182a and a second portion 182b, which have different thicknesses (in the second direction Y) or different numbers of layers, so as to form the non-uniform first portion 182a and second portion 182b.

Therefore, regardless of whether the fast axis (first fast axis) of the first portion 182a is the same as or different from the fast axis (second fast axis) of the second portion 182b, as long as the thickness or number of layers of the first portion 182a can be controlled to be different from that of the second portion 182b, in cooperated with the high reflectivity of the electronic unit 12, the circuit layer (e.g., including metal lines) of the first substrate 11, the reflective layer 13 and the reflectivity matching layer 14, the area corresponding to the first portion 182a and the area corresponding to the second portion 182b can generate different reflected lights, such as different brightness and/or different colors, etc. Therefore, when the electronic device 10C is not lit, the aforementioned preset pattern, such as parallel stripes, wood grains, hair lines, cloud patterns, wavy stripes, a string of characters, an item pattern, a trademark, a character graphic, or the likes, can be viewed from the outer side of the electronic device 10C (e.g., display surface side).

In addition, the anti-reflective layer 19 is disposed at one side of the linear polarizer 181 of the circular polarizing layer 18 away from the second substrate 17. In this embodiment, the anti-reflective layer 19 may be, for example, a multilayer structure including one or more layers of high refractive index material and one or more layers of low refractive index material alternately arranged. Thus, the external ambient light passes through the anti-reflective layer 19 before entering the circular polarizing layer 18, thereby reducing the reflection of the external ambient light at the interface between the circular polarizing layer 18 and the air. The low refractive index material may be, for example, silicon oxide (SiOx), and the high refractive index material may be, for example, silicon nitride (SiNx), niobium oxide (Nb₂O₅), or the likes. This invention is not limited thereto.

The detailed description of other features of the electronic device 10C can refer to the previous embodiment, and will be omitted here.

As shown in FIG. 3B, compared with the previous embodiment of FIG. 3A, the electronic device 10D further includes an adhesive layer 20 disposed at one side of the second substrate 17 away from the first substrate 11, and the reflective layer 13 is disposed at one side of the second substrate 17 close to the first substrate 11. In this embodiment, as shown in FIG. 3B, the second substrate 17 is located on the intermediate layer 15. In the active area AA, the reflective layer 13 is formed on the lower surface of the second substrate 17, and the light absorbing layer 16 is formed at one side of the reflective layer 13 close to the first substrate 11. In the peripheral area PA, the light absorbing layer 16 is formed on the lower surface of the second substrate 17, and the reflectivity matching layer 14 is formed on the lower surface of the circular polarizing layer 18. Therefore, the reflectivity matching layer 14 is located between the circular polarizing layer 18 and the adhesive layer 20.

The detailed description of other features of the electronic device 10D can refer to the previous embodiment, and will be omitted here.

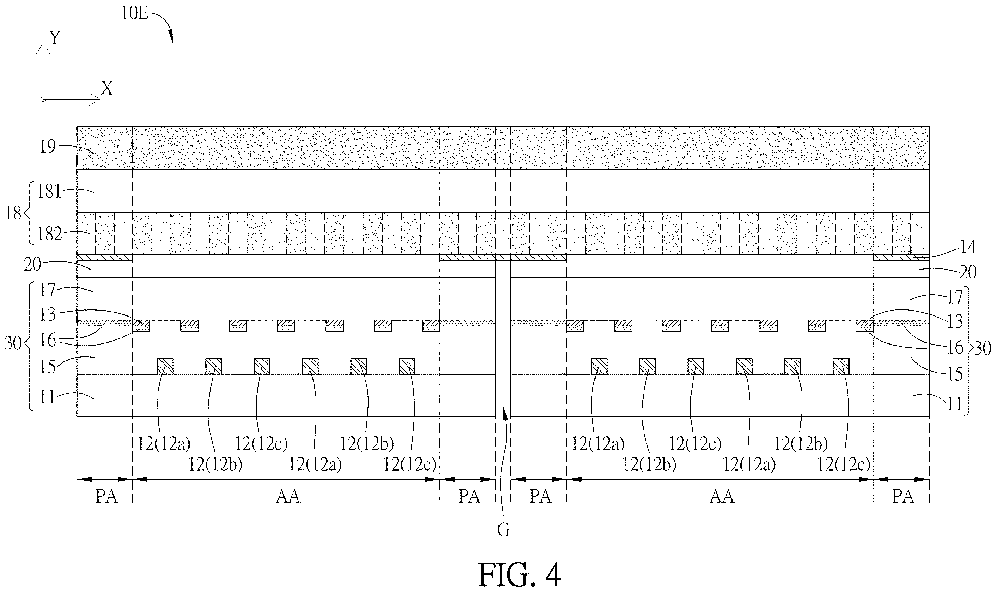

As shown in FIG. 4, compared with the previous embodiment FIG. 3B, the electronic device 10E can be, for example, a tiled electronic device. In this embodiment, a plurality of electronic panel units 30 can be manufactured in advance. Each electronic panel unit 30 includes a first substrate 11, a plurality of electronic units 12, a reflective layer 13, an intermediate layer 15, a light absorbing layer 16, and a second substrate 17. The structural configuration and connection relationship of the electronic panel unit 30 are similar to that of the electronic device 10D shown in FIG. 3B, so the detailed descriptions thereof will be omitted. Next, the plurality of electronic panel units 30 can be placed in a tiling mold, for example, in an array. Afterwards, an adhesive layer 20 is provided on the second substrates 17 of the tiled electronic panel units 30. Finally, the reflectivity matching layer 14, the circular polarizing layer 18, and the anti-reflective layer 19 can be disposed on each electronic panel unit 30 through the adhesive layer 20. In two adjacent electronic panel units 30 of this embodiment, the reflectivity matching layer 14 can be provided within the tiling seam G between the adjacent peripheral areas PA and the two electronic panel units 30. In this case, the sizes of the circular polarizing layer 18 and the anti-reflective layer 19 can be designed to match the overall size of the tiled electronic device.

The detailed description of other features of the electronic device 10E can refer to the previous embodiment, and will be omitted here. To be noted, in the electronic device 10E of this embodiment, the structural configuration of each electronic panel unit 30 refers to the structural configuration of the aforementioned electronic device 10D. In other embodiments, the structural configuration of each electronic panel unit 30 can refer to the structural configuration of any of other electronic devices 10, 10A, 10B and 10C, and the detailed description thereof will be omitted here.

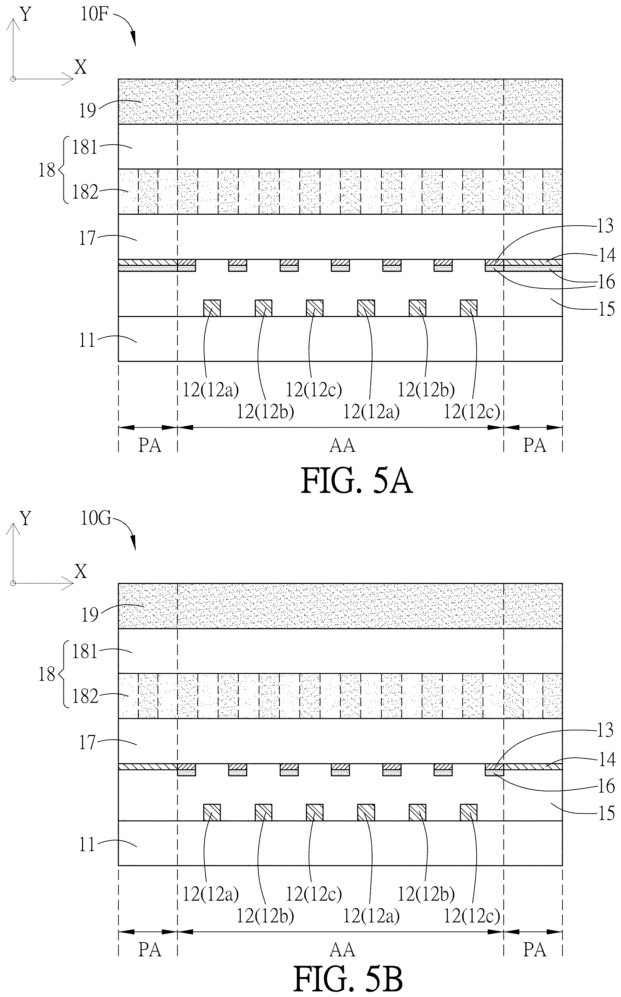

As shown in FIG. 5A, compared with the previous embodiment of FIG. 3A, in the electronic device 10F of this embodiment, the reflective layer 13, the reflectivity matching layer 14, and the light absorbing layer 16 are all disposed at one side of the second substrate 17 close to the first substrate 11. Specifically, in the active area AA, the reflective layer 13 is formed on the lower surface of the second substrate 17, and the light absorbing layer 16 is formed on one side of the reflective layer 13 close to the first substrate 11. In the peripheral area PA, the reflectivity matching layer 14 is formed on the lower surface of the second substrate 17, and the light absorbing layer 16 is formed on one side of the reflectivity matching layer 14 close to the first substrate 11.

The detailed description of other features of the electronic device 10F can refer to the previous embodiment, and will be omitted here.

As shown in FIG. 5B, compared with the previous embodiment of FIG. 5A, in the electronic device 10G of this embodiment, the light absorbing layer 16 is merely formed in the active area AA, but is not formed in the peripheral area PA.

The detailed description of other features of the electronic device 10G can refer to the previous embodiment, and will be omitted here.

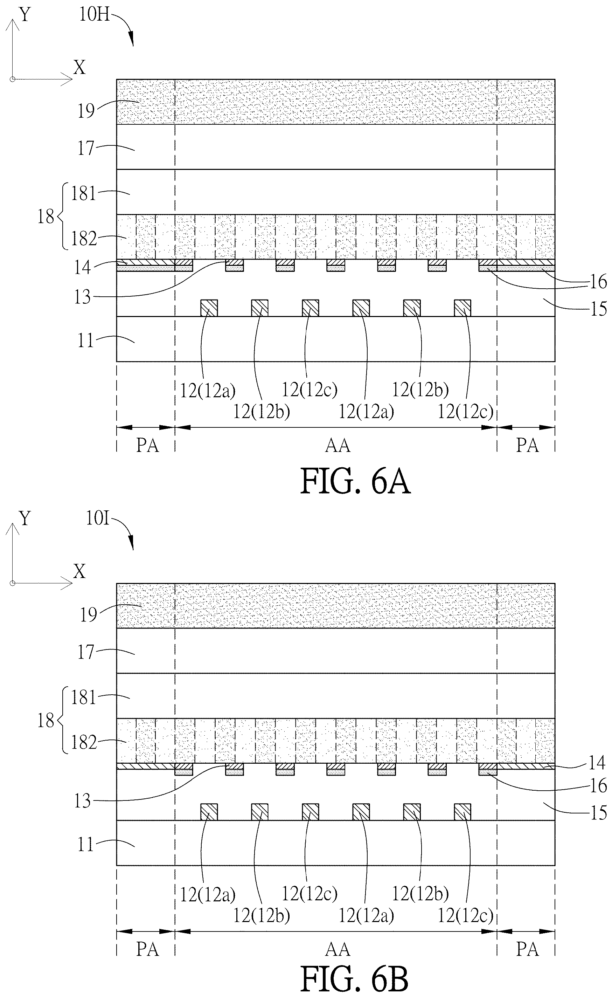

As shown in FIG. 6A, compared with the previous embodiment of FIG. 5A, in the electronic device 10H of this embodiment, the circular polarizing layer 18 is disposed between the second substrate 17 and the reflective layer 13, and between the second substrate 17 and the reflectivity matching layer 14, and the reflective layer 13, the reflectivity matching layer 14 and the light absorbing layer 16 are disposed at one side of the circular polarizing layer 18 close to the first substrate 11. As shown in FIG. 6A, the circular polarizing layer 18 is disposed at one side of the second substrate 17 close to the first substrate 11, and the anti-reflective layer 19 is disposed at one side of the second substrate 17 away from the first substrate 11. In the active area AA, the reflective layer 13 is formed on the lower surface of the circular polarizing layer 18, and the light absorbing layer 16 is formed at one side of the reflective layer 13 close to the first substrate 11. In the peripheral area PA, the reflectivity matching layer 14 is formed on the lower surface of the circular polarizing layer 18, and the light absorbing layer 16 is formed at one side of the reflectivity matching layer 14 close to the first substrate 11.

The detailed description of other features of the electronic device 10H can refer to the previous embodiment, and will be omitted here.

As shown in FIG. 6B, compared with the previous embodiment of FIG. 6A, in the electronic device 10I of this embodiment, the light absorbing layer 16 is merely formed in the active area AA, but is not formed in the peripheral area PA.

The detailed description of other features of the electronic device 101 can refer to the previous embodiment, and will be omitted here.

In summary, the electronic device of this invention includes a first substrate, a plurality of electronic units, a reflective layer and a reflectivity matching layer. The first substrate has an active area and a peripheral area. The electronic units are disposed on the first substrate and located within the active area. The reflective layer is disposed above the first substrate and relatively overlaps the active area of the first substrate. The reflective layer has a plurality of openings relatively overlapping the electronic units, respectively. The reflectivity matching layer is disposed above the first substrate and relatively overlaps the peripheral area of the first substrate. The present invention provides a matching reflection effect in the active area (e.g. the display area) and the peripheral area (e.g. the non-display area) of the electronic device (e.g. a mirror display device) by arranging the reflective layer overlapping the active area of the first substrate and arranging a reflectivity matching layer overlapping the peripheral area of the first substrate, thereby achieving the purpose of a hidden display screen.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic device, comprising:
a first substrate having an active area and a peripheral area;
a plurality of electronic units disposed on the first substrate and located within the active area;
a reflective layer disposed above the first substrate and relatively overlapping the active area of the first substrate, wherein the reflective layer has a plurality of openings relatively overlapping the electronic units, respectively; and
a reflectivity matching layer disposed above the first substrate and relatively overlapping the peripheral area of the first substrate.

2. The electronic device of claim 1, further comprising:
a light absorbing layer disposed at one side of the reflective layer close to the first substrate.

3. The electronic device of claim 2, wherein the light absorbing layer is further disposed at one side of the reflectivity matching layer close to the first substrate.

4. The electronic device of claim 1, wherein the reflective layer comprises a metal material, and the reflectivity matching layer comprises a metal material.

5. The electronic device of claim 1, wherein each of the reflective layer and the reflectivity matching layer comprises a multilayer structure including at least one high reflectivity layer and at least one low reflectivity layer, which are alternately stacked.

6. The electronic device of claim 1, further comprising:
a circular polarizing layer disposed above the reflective layer and the reflectivity matching layer.

7. The electronic device of claim 6, wherein the circular polarizing layer comprises a linear polarizer and a phase retarder, and the linear polarizer is disposed on the phase retarder.

8. The electronic device of claim 7, wherein the phase retarder comprises a first portion and a second portion arranged next to each other.

9. The electronic device of claim 8, wherein:
a phase retardation of the first portion is different from a phase retardation of the second portion; or
the first portion comprises a first fast axis, the second portion comprises a second fast axis, the linear polarizer comprises a transmission axis, and an angle between the first fast axis and the transmission axis is different from an angle between the second fast axis and the transmission axis.

10. The electronic device of claim 6, further comprising:
an anti-reflective layer disposed at one side of the circular polarizing layer away from the first substrate.

11. The electronic device of claim 6, further comprising:
a second substrate disposed opposite to the first substrate, wherein the electronic units are located between the first substrate and the second substrate.

12. The electronic device of claim 11, wherein the reflective layer is disposed at one side of the second substrate close to the first substrate, and the reflectivity matching layer is disposed at one side of the second substrate away from the first substrate.

13. The electronic device of claim 12, further comprising:
an adhesive layer disposed between the circular polarizing layer and the second substrate.

14. The electronic device of claim 11, wherein the reflective layer and the reflectivity matching layer are both disposed at one side of the second substrate close to the first substrate.

15. The electronic device of claim 14, wherein the circular polarizing layer is disposed between the second substrate and the reflective layer, and between the second substrate and the reflectivity matching layer.
